# EUROPEAN PATENT APPLICATION

(11) **EP 0 926 940 A1**
(43) Date of publication of application: **30.06.1999**
(21) Application number: 98123360.4
(22) Date of filing: 08.12.1998
(51) Int. Cl.: H05K 9/00

(54) **Method and apparatus for providing RF shielding in a PCMCIA standard enclosure**

(30) Priority: 11.12.1997 US 989187
(71) Applicant: INTERMEC IP CORP., Beverly Hills, California 90210 (US)
(72) Inventor: Jonanovich, Alan F., Des Moines, Washington 98198 (US); Warren, Bruce G., Poulsbo, Washington 98370 (US); Mensonides, John W., Monroe, Washington 98272 (US)
(74) Representative: MÜLLER & HOFFMANN Patentanwälte

(57) **Abstract**

An improved method and apparatus for shielding electrical components within a compact enclosure is particularly applicable to compact enclosures having narrow cross-section, such as PC Cards. The compact enclosure (10) comprises a conductive metallic housing with a circuit board disposed therein, wherein shielding of at least one component of the circuit board from extraneous RF signals is required. A conductive shield circumscribes the component (22) of the circuit board (16) on all sides and has an open top portion. The conductive shield further comprises a vertical wall (32) having a bottom edge and a top edge. The bottom edge is coupled to the circuit board flush with a surface of the circuit board and is coupled to a ground trace (36) thereof. A plurality of conductive spring fingers (34) extend from the top edge of the conductive shield, and are adapted to come into contact with a portion of an interior surface (12) of the conductive metallic housing of the enclosure to provide an electrical connection therebetween. The conductive shield and the portion of the interior surface of the conductive metallic housing provide an RF shield for the component, and permit the component to have a height that extends all the way to the interior surface of the housing.

## Description

### BACKGROUND OF THE INVENTION

### 1. Field of the Invention

The present invention relates to radio frequency (RF) communications systems, and more particularly, to a radio transceiver within a compact enclosure in which an RF shield is integrated with the enclosure cover to provide electrical shielding of individual components of the transceiver against extraneous RF signals.

### 2. Description of Related Art

Portable wireless communications systems are increasingly prevalent in the art as a convenient way to permit remote elements of a complex system to operate together. A particularly useful application of wireless communication is that of a wireless local area network ("LAN") in which a plurality of remote computing devices communicate together using radio frequency ("RF") signals. A central host processing unit of the wireless LAN can send information to and receive information from any one of the plurality of remotely disposed computing devices. In such a wireless LAN, the remote computing devices may comprise portable, semi-autonomous units that operate within a specified environment to collect and report information back to the central host processing unit.

Each of the remote computing devices comprise a radio transmitter/receiver ("transceiver") portion that permits the remote computing device to communicate with the other elements of the wireless LAN over an RF carrier frequency. The radio transceiver portion converts the received RF signals to digital data signal for further processing by the digital portion of the remote computing devices, and conversely, the transceiver portion converts the digital signals from the digital portion of the remote computing devices to RF signals to be transmitted. These wireless LAN systems offer increased flexibility over hard-wired systems by enabling operators of the remote computing devices substantial freedom of movement through the environment. In view of the portable nature of the remote computing devices, it is desirable to integrate the transceiver circuitry into a compact package with reduced weight and power requirements.

Within the personal computer ("PC") industry, it' is known to incorporate peripheral components into a standard-sized package in accordance with an industry standard, referred to as the Personal Computer Memory Card International Association ("PCMCIA") standard. The PCMCIA standard defines the physical and electrical characteristics of a PC Card which includes a 68-pin interface between the PC and the card. There are three standard sizes of PC Cards defined by the PCMCIA standard, including a Type I, Type II and Type III PC Card. A Type I PC Card is the smallest form factor, with a thickness of only 3.3 mm. A Type II PC Card has a thickness of 5 mm, and a Type III PC Card has a thickness of 10.5 mm. A printed circuit board and other such electrical components may be disposed within the housing of the PC Card. The PC Card is adapted to be inserted into a corresponding socket of a personal computer, enabling the card to communicate directly with the central processing unit ("CPU") of the personal computer in the same manner as other permanently installed peripheral devices. PC Cards have been adapted to provide various peripheral functions, most particularly as fax/modems, LAN adapters, and data storage devices.

One application for PC Cards that is particularly useful for wireless LAN systems is to provide an RF transceiver. A PC Card transceiver would enable portable computers, such as so-called laptop computers, palmtop computers and personal data assistants ("PDAs"), to communicate within wireless LAN systems. A drawback with the PC Card standard format is that even its largest form factor is still too narrow to accommodate the size of certain electrical components that are common to RF transceiver circuitry. Certain RF components, such as filters and transformers, cannot readily be reduced in size in the same manner that digital circuitry that can be integrated into semiconductor packages. More significantly, these RF components require shielding to prevent extraneous RF signals from external circuitry, as well as from other RF components of the same transceiver circuit, from being coupled into the components. The shielding also prevents extraneous RF signals from the particular RF components from being coupled into other components of the transceiver circuit or other external systems. Generally, the shielding comprises a grounded conductive enclosure that physically surrounds the component and couples any such extraneous RF signals to ground. Unfortunately, the shielding of the RF components takes up precious space within the standard PC Card package, thereby increasing the cost and complexity of providing an acceptable RF transceiver application for a PC Card.

Accordingly, it would be desirable to provide a method and apparatus for shielding electrical components from extraneous RF signals within a compact package which requires less physical space than conventional component shielding. It would be further desirable to provide such a method and apparatus for use within a standard PC Card to provide a transceiver application.

### SUMMARY OF THE INVENTION

In accordance with the teachings of the present invention, an improved method and apparatus for shielding electrical components within a compact enclosure is provided. The present method and apparatus is particularly applicable to compact enclosures having narrow cross-section, such as conventional PC Cards.

Particularly, the present shielding apparatus and method is adapted for use with a compact enclosure comprising a conductive metallic housing with a circuit board disposed therein, wherein shielding of at least one component of the circuit board from extraneous RF signals is required. The component is circumscribed by a conductive shield which has an open top portion. The conductive shield further comprises a vertical wall having a bottom edge and a top edge. The bottom edge is flush with a surface of the circuit board and is coupled to a ground trace thereof. A plurality of conductive spring fingers extend from the top edge of the conductive shield, and are adapted to come into contact with a portion of an interior surface of the conductive metallic housing of the enclosure to provide an electrical connection therebetween. The conductive shield and the portion of the interior surface of the conductive metallic housing provide an RF shield for the component, and permit the component to have a height that extends all the way to the interior surface of the housing.

In an embodiment of the invention, the spring fingers and the conductive shield are integrally formed from a sheet of foil material, such as beryllium copper. Individual ones of the spring fingers are separated by a distance much less than one-quarter of a wavelength of the extraneous RF signals intended to be shielded by the conductive shield. The spring fingers are adapted to extend generally inward of a region enclosed by the conductive shield. The natural spring bias of the spring fingers maintains electrical contact between the conductive shield and the housing.

A more complete understanding of the method and apparatus for providing RF shielding for a PCMCIA standard enclosure will be afforded to those skilled in the art, as well as a realization of additional advantages and objects thereof, by a consideration of the following detailed description of the preferred embodiment. Reference will be made to the appended sheets of drawings which will first be described briefly.

### BRIEF DESCRIPTION OF THE DRAWINGS

Fig. 1 is a partial sectional side view of a prior art PCMCIA standard enclosure illustrating a printed circuit board disposed within a conductive metallic housing;
Fig. 2 is an enlarged portion of the prior art PCMCIA standard enclosure of Fig. 1, illustrating a circuit component mounted on the printed circuit board;
Fig. 3 is an enlarged portion of the prior art PCMCIA standard enclosure as in Fig. 2, illustrating a conventional RF shield enclosing the circuit component mounted on the printed circuit board;
Fig. 4 is a partial sectional side view of a PCMCIA standard enclosure with an RF shield of the present invention;
Fig. 5 is an enlarged side view of the RF shield; and
Fig. 6 is a perspective view of a printed circuit board of a PCMCIA standard enclosure with the RF shield circumscribing certain circuit components.

### DETAILED DESCRIPTION OF THE PREFERRED EMBODIMENT

The present invention satisfies the need for a method and apparatus for shielding electrical components from extraneous RF signals within a compact package which requires less physical space than conventional component shielding, and is particularly applicable for use within a standard PCMCIA card to provide a transceiver application.

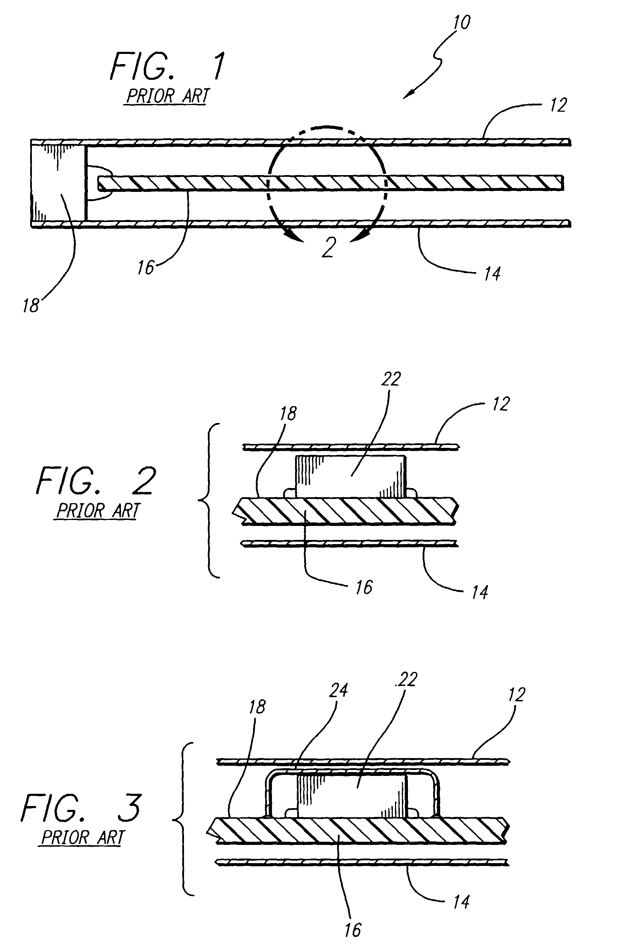

Referring first to Figs. 1-3, a side sectional view of a PCMCIA standard enclosure 10, or PC card, is illustrated. As shown in Fig. 1, the PC card 10 has a metallic housing including a top cover 12 and a bottom cover 14. The top and bottom covers 12, 14 may actually be constructed from a single piece formed into a sleeve configuration. A connector 18 is provided at an end of the housing, and is adapted to be connected with a corresponding socket of a PC (not shown), such as a laptop, palmtop or PDA. According to the PCMCIA standard, the connector 18 defines a 68-pin interface between the PC and the PC card 10. The connector 18 is connected electrically and structurally to a printed circuit board 16, which is suspended between the top and bottom covers 12, 14. As known in the art, various electrical components will be coupled to the printed circuit board 16.

As noted above, there are three standard sizes of PC Cards defined by the PCMCIA standard, including a Type I, Type II and Type III PC Card. The Type II is the most widely used form factor of the three PC Card sizes, and for exemplary purposes it is used in the following description, though it should be appreciated that the teachings of the present invention are also applicable to the other sizes of PC Card as well as to any other like enclosure. With a total thickness of 5 mm (0.19 inches), and an estimated thickness of 0.031 inches for the printed circuit board 16, it should be appreciated that only about 0.080 inches of clearance remains in the space above the printed circuit board.

As shown in Fig. 2, an electrical component 22 mounted on the printed circuit board 16 almost fills the space provided between the printed circuit board and the interior surface of the top cover 12. While conventional solid state circuitry can be adapted into packages having very low cross section, certain components used with RF circuitry have much greater space requirements, and cannot easily be reduced to fit a smaller form factor. For example, a conventional filter element for an RF circuit has a height of 0.080 inches, which would entirely fill the space above the printed circuit board. RF shielding requirements further exacerbate the space problem. Fig. 3 illustrates a conventional RF shield 24 enclosing the circuit component 22 on its sides and at the top. The RF shield 24 is comprised of conductive metal, and is electrically connected to a ground trace of the printed circuit board to couple any extraneous RF signals into ground without being coupled into the component 22. The typical RF shield 24 has a material thickness of 0.006 inches, which further reduces the available space to 0.072 inches. It should be appreciated that this space is inadequate to accommodate the exemplary filter circuit component described above as having a height of 0.080 inches.

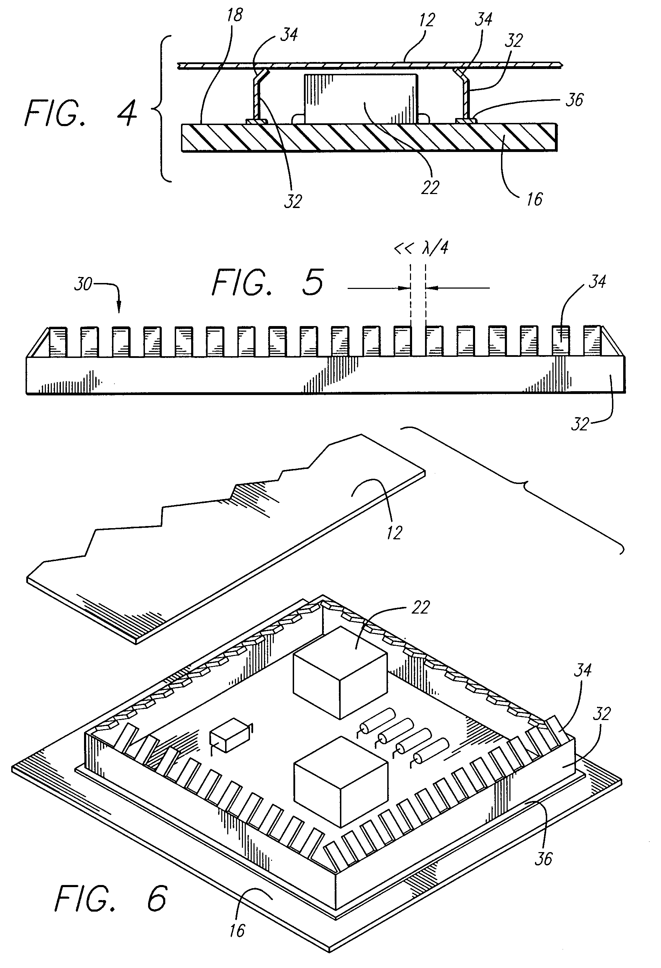

Referring now to Figs. 4-6, an RF shielding apparatus of the present invention is illustrated. As shown in Fig. 5, the RF shielding 30 comprises a thin sheet of electrically conductive material. The RF shielding 30 further comprises a wall portion 32 having a bottom edge and a top edge, and a plurality of fingers 34 extending from the top edge. The fingers 34 are provided along the entire length of the top edge, and are spaced apart by a distance much less than one-quarter of a wavelength (λ/4) of the highest frequency of an RF signal to which attenuation is desired. For example, in a preferred embodiment of the invention, a spacing of one-fifth of λ/4 is utilized. A slight angle is formed between the the fingers 34 and the wall portion along the top edge so that the fingers provide spring contacts, as will be further described below.

The RF shielding 30 should be comprised of a conductive material having generally elastic properties, such as beryllium copper. The pattern of the RF shielding 30 may be made from an initial sheet of material by chemical etching or like techniques. Then, the fingers 34 may be bent or folded slightly along the top edge. Thereafter, the RF shielding 30 may be heat treated to provide elasticity to the fingers 34. It should be appreciated by those skilled in the art that other materials could also be utilized for making the RF shielding, and other techniques for imprinting the desired pattern of the RF shielding could also be employed.

Figs. 4 and 6 illustrate the RF shielding 30 in use within a PC Card. As shown in Fig. 4, the bottom edge of the wall portion 32 is coupled to a ground trace 36 formed on the surface of the printed circuit board 16. The wall portion 32 may be attached to the ground trace 36 by soldering or other like process to form a rigid structural and electrical connection. The wall portion 32 extends perpendicularly from the surface of the printed circuit board, and may be folded in the perpendicular dimension to form corners so as to entirely circumscribe an electrical component 22, as shown in Fig. 6. The fingers 34 are bent inwardly of the region circumscribed by the RF shielding 30.

When the printed circuit board 16 is inserted into the housing of the PC Card, the fingers 34 come into contact with the interior surface of the top cover 12. The pressure of the top cover 12 causes the fingers 34 to bend downwardly along the fold line defined by the top edge of the wall portion 32 against the natural spring bias of the fingers. This results in good electrical connection between the top cover 12 and the fingers 34. As a result, the region of the top cover 12 defined by the RF shielding 30 provides a portion of the RF shielding to enclose the electrical component 22. Thus, the electrical component 22 can have a height that extends entirely to the top cover 12. The use of a plurality of fingers 34 disposed along the entire length of the RF shielding 30 ensures a good electrical connection between the top cover 12 and the RF shielding, and precludes any gaps that would permit extraneous RF signals from leaking through the RF shielding either to or from the component 22.

Having thus described a preferred embodiment of the method and apparatus for shielding components within a PCMCIA standard enclosure from extraneous RF signals, it should be apparent to those skilled in the art that certain advantages of the within system have been achieved. It should also be appreciated that various modifications, adaptations, and alternative embodiments thereof may be made within the scope and spirit of the present invention. The invention is further defined by the following claims.

## Claims

1. In a compact enclosure having a conductive metallic housing with a circuit board disposed within the housing, the circuit board further having at least one component susceptible to extraneous RF signals, an improvement comprises:
a conductive shield comprising a vertical wall having a bottom edge and a top edge, said bottom edge being flush with a surface of said circuit board and coupled to a ground trace thereof, the conductive shield circumscribing said at least one component of said circuit board on all sides with an open top portion; and
a plurality of conductive spring fingers extending from said top edge of said conductive shield, said spring fingers being adapted to come into contact with a portion of an interior surface of said conductive metallic housing of said enclosure to provide an electrical connection therebetween;
wherein said conductive shield and said portion of said interior surface of said conductive metallic housing provides a RF shield for said at least one component.

2. The improvement to a compact enclosure of Claim 1, wherein said compact enclosure further comprises a PC Card.

3. The improvement to a compact enclosure of Claim 1, wherein individual ones of said spring fingers are separated by a distance substantially less than one-quarter of a wavelength of a highest frequency of said extraneous RF signals.

4. The improvement to a compact enclosure of Claim 1, wherein said conductive shield is comprised of beryllium copper.

5. The improvement to a compact enclosure of Claim 1, wherein said spring fingers are integrally provided with said conductive shield.

6. The improvement to a compact enclosure of Claim 1, wherein said spring fingers extend inwardly of a region enclosed by said conductive shield.

7. A compact peripheral device comprises:
a conductive metallic housing having a rectangular shape with a narrow cross-section;
a circuit board disposed within the housing, the circuit board further having at least one electrical component susceptible to extraneous RF signals;
an electrical connector coupled to said circuit board and disposed at an end of said housing;
a conductive shield comprising a vertical wall having a bottom edge and a top edge, said bottom edge being flush mounted to said circuit board, the conductive shield substantially circumscribing said at least one component of said circuit board with an open top portion; and
means for electrically connecting said top edge of said conductive shield to an interior surface of said conductive metallic housing, wherein said conductive shield and said interior surface of said conductive metallic housing provides a RF shield for said at least one component.

8. The compact peripheral device of Claim 7, wherein said conductive shield is coupled to a ground trace of said circuit board.

9. The compact peripheral device of Claim 7, further comprising a PC Card.

10. The compact peripheral device of Claim 7, wherein said connecting means further comprises a plurality of conductive spring fingers extending from said top edge of said conductive shield, said spring fingers being adapted to contact with a portion of an interior surface of said conductive metallic housing and provide an electrical connection therebetween.

11. The improvement to a compact enclosure of Claim 9, wherein said spring fingers extend inwardly of a region enclosed by said conductive shield.

12. The compact peripheral device of Claim 9, wherein individual ones of said spring fingers are separated by a distance substantially less than one quarter of a wavelength of a highest frequency of said extraneous RF signals.

13. The compact peripheral device of Claim 9, wherein said spring fingers are integrally provided with said conductive shield.

14. The compact peripheral device of Claim 7, wherein said conductive shield is comprised of beryllium copper.

15. The compact peripheral device of Claim 7, further comprising an RF transceiver.

16. A method for providing component shielding within a compact enclosure having a conductive metallic housing and an internal circuit board having at least one component susceptible to extraneous RF signals, the method comprising the steps of:
circumscribing said at least one susceptible component of said circuit board on all sides with a conductive shield leaving an open top, said conductive shield further comprising a vertical wall having a bottom edge and a top edge, said bottom edge being flush with a surface of said circuit board and coupled to a ground trace thereof;
extending a plurality of conductive spring fingers from said top edge of said conductive shield; and
inserting said circuit board into said housing such that said spring fingers come into contact with and press against a portion of an interior surface of said housing to provide an electrical connection therebetween.

17. The method of Claim 16, wherein said step of extending a plurality of spring fingers further comprises extending said spring fingers inwardly of a region enclosed by said conductive shield.

18. The method of Claim 16, wherein said step of extending a plurality of spring fingers further comprises spacing individual ones of said spring fingers by a distance substantially less than one quarter of a wavelength of a highest frequency of said extraneous RF signals.
